# EUROPÄISCHE PATENTSCHRIFT

(11) **EP 0 924 971 B1**
(45) Veröffentlichungstag und Bekanntmachung des Hinweises auf die Patenterteilung: **27.10.2004**
(21) Anmeldenummer: 98122968.5
(22) Anmeldetag: 03.12.1998
(51) Int. Cl.: H05K 3/36, H01R 12/04, H05K 5/02

(54) **Anordnung zur Kontaktierung von Leiterplatten**
Device for connecting printed circuit boards
Dispositif pour la connexion de plaques à circuit imprimé

(30) Priorität: 18.12.1997 DE 19756345
(43) Veröffentlichungstag der Anmeldung: 23.06.1999
(73) Patentinhaber: Conti Temic Microelectronic GmbH, 90411 Nürnberg (DE)
(72) Erfinder: Baur, Richard, 85276 Pfaffenhofen (DE); Bischoff, Michael, 85111 Adelschlag (DE); Fendt, Günter, 86529 Schrobenhausen (DE)

(56) Entgegenhaltungen:
- DE-A- 4 340 280
- GB-A- 2 110 006
- US-A- 5 657 203
- PATENT ABSTRACTS OF JAPAN vol. 016, no. 521 (E-1285), 27. Oktober 1992 (1992-10-27) & JP 04 196160 A (TOSHIBA CORP), 15. Juli 1992 (1992-07-15)

## Beschreibung

Die Erfindung betrifft eine Anordnung zur Kontaktierung von Leiterplatten nach dem Oberbegriff des Anspruchs 1.

Um verschiedene, meistens innerhalb eines Gehäuses angeordnete Leiterplatten elektrisch miteinander zu verbinden, werden überwiegend Steckverbindungen benutzt, wobei meistens Stecker einer mehradrigen Verbindungsleitung in korrespondierende Aufnehmer gesteckt werden, die auf den Leiterplatten angeordnet sind. Befinden sich zwei miteinander zu verbindende Leiterplatten in unmittelbarer Nähe, ist vielfach der Stecker auf der einen und die korrespondierende Aufnahme auf der anderen Leiterplatte angeordnet, so dass die Verbindungsleitung entfällt.

Derartige Lösungen weisen den Nachteil auf, dass die Kosten für die Steckverbindung und gegebenenfalls die Verbindungsleitung eine Leiterplatte merklich verteuern. Die Zuverlässigkeit derartiger Verbindungen ist nicht sehr hoch. Außerdem vergrößern sich durch die Abmessungen des Steckers oder der Aufnahme auch die Abmessungen der Leiterplatte, was ebenfalls Mehrkosten nach sich zieht. Das mit der nötigen Sorgfalt durchzuführende Zusammenstecken von Stecker und Aufnahme während der Montage erhöht zudem Montagezeit und Montagekosten.

Bekannt sind auch andere Lösungen zum Befestigen und/oder Kontaktieren von Trägem und Leiterplatten. So beschreibt die DE 43 40 280 A1 einen Bauteilesatz für ein Gehäuse mit Rahmen, Boden und Deckel aus Kunststoff zum Aufnehmen von elektrischen Bauelementen, Sensoren und/oder Schaltungen, die auf Schattungsträgerplatten angeordnet sind. An einer Wand des Rahmens ist ein Vorsprung ausgebildet, in welchen Kontaktstifte eingebettet sind, welche je nach Anwendungsfall mit Leitern einer Steckerleiste Verbindung haben oder nicht; im zuletzt genannten Fall dienen sie nur als Hafteelemente für eine Schaltungsträgerplatte. Die Schaltungsträgerplatte hat zu diesem Zweck Bohrungen, die von Federklemmen übergriffen werden, in welche die Stifte durch die Schattungsträgerplatte hindurchgreifend eingepresst werden können.

Die US 5,657,203 beschreibt ebenfalls ein Gehäuse mit Rahmen, Boden und Deckel zur Aufnahme von elektrischen Bauelementen, die auf Schaltungsträgerplatten angeordnet sind. Die beiden Schaltungsträgerplatten sind hierbei über eine in den Rahmen eingebrachte Verbindungsleitung in Vielstiftstruktur und über Bonddrähte elektrisch miteinander verbunden.

Es ist daher Aufgabe der Erfindung, eine Anordnung zur Kontaktierung von Leiterplatten in einem Gehäuse anzugeben, mit der die vorgenannten Nachteile vermieden werden.

Diese Aufgabe wird gelöst durch die Merkmale des Anspruchs 1, wonach zur Kontaktierung von wenigstens zwei, in einem Gehäuse angeordneten und erste Kontaktmittel aufweisende Leiterplatten, im Gehäuse wenigstens eine Kontaktierungsbrücke angeordnet ist, die elektrisch leitfähige Verbindungsleitungen aufweist, deren Enden jeweils als zweite Kontaktmittel ausgebildet sind, zur elektrischen Verbindung die Leiterplatten mittels der Kontaktierungsbrücke derart zueinander positioniert sind, dass die ersten Kontaktmittel mit den zweiten Kontaktmitteln in Eingriff stehen, und die Kontaktierungsbrücke zur Kontaktierung von nebeneinander angeordneten Leiterplatten gemeinsame Auflageflächen aufweist.

Die Vorteile der Erfindung bestehen darin, dass zur elektrischen Verbindung von Leiterplatten innerhalb eines Gehäuses keine Steckverbindungen und Verbindungsleitungen notwendig sind. Außerdem benötigen die Kontaktstellen nur wenig Platz, so dass sich die Abmessungen verkleinern können und dadurch Kosten eingespart werden. Durch das bei der Montage entfallende Zusammenstecken von Stecker und Aufnahme verkürzt sich die Montagezeit spürbar, die Zuverlässigkeit der elektrischen Verbindung wird erhöht.

Vorteilhaft ist es, wenn entweder die ersten Kontaktstellen der Leiterplatten als Kontaktstellen und die zweiten Kontaktstellen der Kontaktierungsbrücke als Kontaktstifte oder die ersten Kontaktstellen der Leiterplatten als Kontaktstifte und die zweiten Kontaktstellen der Kontaktierungsbrücke als Kontaktstellen ausgebildet sind. Bei den jeweiligen Kontaktstiften handelt es sich vorteilhaft um Einpressstifte oder Federstifte.

Weitere vorteilhafte Ausbildungen der Erfindung sind in den weiteren Unteransprüchen beschrieben.

Ein Ausführungsbeispiel der Erfindung ist nachstehend ausführlich erläutert und anhand einer Figur dargestellt.

Die Figur zeigt ein Gehäuseteil 1 aus Kunststoff als Teil eines Steuergerätes, das beispielsweise die Auslöseelektronik einer Insassenschutzvorrichtung für ein Fahrzeug enthält. Zur Befestigung am Fahrzeug mittels Schrauben, Nieten o.ä. sind Befestigungslaschen 2 an das Gehäuse 1 angeformt. Ebenfalls an das Gehäuse angeformt sind stabförmige Stützen 3, die zur genauen Positionierung nach Höhe und Seite von im Gehäuse 1 angeordneten Leiterplatten 4 und 5 dienen. Zur genauen Positionierung nach der Höhe weisen die Stützen 3 eine (nicht sichtbare) Abstufung auf.

Auf allen Leiterplatten 4 und 5 sind elektrotechnische Komponenten 6 und Kontaktstellen 7 als erste Kontaktmittel zur Kontaktierung angeordnet, die mittels Leitbahnen 8 miteinander verbunden sind. Zudem weisen die Leiterplatten 4 und 5 Aussparungen 9 zur Positionierung innerhalb des Gehäuses 1 auf.

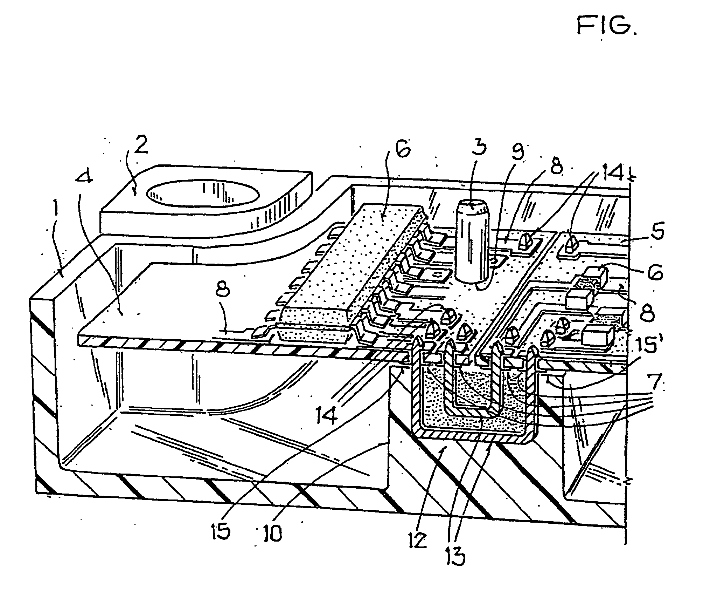

Eine beispielsweise quaderförmige und aus einem Block bestehende Kontaktierungsbrücke 10 mit ebenen Auflageflächen 15 und 15' dient vorzugsweise zur Kontaktierung von zwei nebeneinander und mit jeweils gleichem Abstand zum Gehäuseboden angeordneten Leiterplatten 4 und 5, wie in Fig. 1 dargestellt. Die Kontaktierungsbrücke 10 kann auch eine andere Gestalt aufweisen, beispielsweise eine solche, die einer (Strassen-)Brücke ähnlich ist oder eine Abwandlung davon.

Zur Kontaktierung sind in einen quaderförmigen Block 12, der Teil des Gehäuses 1 ist, leitfähige Verbindungsleitungen 13 eingelegt, die jeweils mit ihren beiden Enden als zweite Kontaktmittel in Form von Kontaktstiften 14 geringfügig aus dem Block 12 herausragen. An ihren Enden sind die Kontaktstifte 14 beispielsweise als Einpressstifte oder als Federstifte oder auf andere Art und Weise ausgebildet, so dass zwischen ihnen und den Kontaktstellen 7 der Leiterplatten 4 und 5 ein niederohmiger und dauerhafter Kontakt zustande kommt.

Eine andere Möglichkeit besteht darin, die ersten und zweiten Kontaktmittel zu vertauschen, also die ersten Kontaktmittel auf den Leiterplatten 4 und 5 als Kontaktstifte und die zweiten Kontaktstellen am Ende der Verbindungsleitungen 13 als Kontaktstellen auszubilden.

Es ist weiterhin möglich, die Kontaktierungsbrücke 10 separat zur fertigen und mit dem Gehäuse 1 mittels Verschraubung, Verrastung, Klebung oder auf sonstige Art und Weise zu verbinden, sie an das Gehäuse 1 anzuspritzen oder, wie in beiden Ausführungsbeispielen gezeigt, in einem Arbeitsschritt mittels Spritzgiessen an das Gehäuse 1 anzuformen. Die Zwischenräume zwischen den Verbindungsleitungen 13 sind jeweils vorzugsweise mit Kunststoff oder einem anderen nichtleitenden Vergussmaterial oder Füllstoff befüllt.

Bei der Kontaktierung zwischen den Leiterplatten 4 und 5 bzw. zur Kodierung sind verschiedene Ausgestaltungen der Kontaktierungsbrücke 10 möglich, beispielsweise:
- die Kontaktierungsbrücke 10 weist viele Kontaktstifte 14 auf, und auf den Leiterplatten 4, 5 sind nur die jeweils notwendigen Kontaktstellen 7 mit Leitbahnen 8 verbunden, oder
- die Kontaktierungsbrücke 10 weist nur die erforderlichen Kontaktstifte 14 und die Leiterplatten 4, 5 nur die notwendigen, mit Leitbahnen 8 verbundenen Kontaktstellen 7 auf.

Die Kontaktierungsbrücke 10 dient neben der Kontaktierung auch zur Abstützung der Leiterplatten 4 und 5.

Bei der Montage werden die Leiterplatten 4 und 5 in das bereits mit Stützen 3 und Kontaktierungsbrücke 10 versehene Gehäuseteil 1 derart eingelegt, dass jede Stütze 3 durch die korrespondierende Aussparung 9 geführt wird. Dadurch kommen die Kontaktstellen 7 auf den Kontaktstiften 14 der Kontaktierungsbrücke 10 zu liegen und es entsteht zwischen ihnen ein elektrisch leitender Kontakt. Sind die Enden der Kontaktstifte 14 als Einpressstifte ausgeformt, so weisen die Kontaktstellen 7 vorteilhaft eine Bohrung auf. Bei der Montage werden in diesem Fall die Leiterplatten 4, 5 auf die Kontaktierungsbrücke 10 aufgedrückt, wodurch die Kontaktstifte 14 im Sinne der Einpresstechnik in die Bohrungen eingepresst werden und einen sehr dauerhaften und gut leitenden Kontakt ergeben.

Sind die Enden der Kontaktstifte 14 als Federstifte ausgebildet, so müssen die Leitterplatten 4 oder 5 mittels Niederhalter, Einhakmittel oder an den (nicht dargestellten) Gehäusedeckel angeformten Abstandshalter gegen die Kontaktierungsbrücke 10 gedrückt werden, damit ein sicherer Kontakt zwischen den Kontaktstellen 7 und den Federstiften 14 zustande kommt.

Zu den bereits genannten Vorteilen kommt hinzu, dass die wenigen Einzelteile dieser erfindungsgemässen Anordnung zur Kontaktierung von Leiterplatten bei einer Demontage des Steuergeräts leicht und sortenrein voneinander getrennt und als Ausgangsstoffe wiederverwertet werden können.

## Patentansprüche

1. Anordnung zur Kontaktierung von wenigstens zwei, in einem Gehäuse (1)angeordneten Leiterplatten (4, 5), wobei
a) jede Leiterplatte (4, 5) erste Kontaktmittel (7) aufweist,
b) im Gehäuse (1) wenigstens eine Kontaktierungsbrücke (10) angeordnet ist, die elektrisch teitfähige Verbindungsleitungen (13) aufweist, wobei deren Enden jeweils als zweite Kontaktmittel (14) ausgebildet sind und
c) zur elektrischen Verbindung die Leiterplatten (4, 5) mittels der Kontaktierungsbrücke (10) derart zueinander positioniert sind, daß die ersten Kontaktmittel (7) mit den zweiten Kontaktmitteln (14) in Eingriff stehen,
**dadurch gekennzeichnet, dass**
d) die Kontaktierungsbivcke (10) zur Kontaktierung von nebeneinander angeordneten Leiterplatten (4, 5) demeinsame Auflageflächen (15, 15') aufweist.

2. Anordnung nach Anspruch 1, **dadurch gekennzeichnet, daß** die Kontaktierungsbrücke (10) im Bereich der zweiten Kontaktmittel (14) für jede Leiterplatte (4, 5) wenigstens eine Auflagefläche (15, 15') aufweist.

3. Anordnung nach Anspruch 1 oder 2, **dadurch gekennzeichnet, daß** die Kontaktierungsbrücke (10) als Block (12) aus nichtleitendem Material besteht.

4. Anordnung nach einem der Ansprüche 1 bis 3, **dadurch gekennzeichnet, daß** die Verbindungsleitungen (13) in den Block (12) integriert sind, insbesondere durch Vergießen.

5. Anordnung nach einem der vorangehenden Ansprüche, **dadurch gekennzeichnet, daß** die ersten Kontaktmittel (7) der Leiterplatten (4, 5) als Kontaktstellen und die zweiten Kontaktmittel (14) der Kontaktierungsbrücke (10) als Kontaktstifte ausgebildet sind.

6. Anordnung nach einem der vorangehenden Ansprüche, **dadurch gekennzeichnet, daß** die ersten Kontaktmittel (7) der Leiterplatten (4, 5) als Kontaktstifte und die zweiten Kontaktmittel (14) der Kontaktierungsbrücke (10) als Kontaktstellen ausgebildet sind.

7. Anordnung nach Anspruch 5 oder 6, **dadurch gekennzeichnet, daß** die Kontaktstifte (14) als Federstifte ausgebildet sind.

8. Anordnung nach Anspruch 5 oder 6, **dadurch gekennzeichnet, daß** die Kontaktstifte (14) als Einpreßstifte ausgebildet sind.

## Claims

1. An arrangement for contacting at least two printed circuit boards (4, 5) arranged in a housing (1), wherein
a) each printed circuit board (4, 5) comprises first contact means (7),
b) at least one contacting bridge (10) is arranged in the housing (1) and comprises electrically conductive connecting leads (13) whose respective ends are in the form of second contact means (14) and
c) for the purposes of establishing an electrical connection, the printed circuit boards (4, 5) are positioned relative to one another by means of the contacting bridge (10) in such a manner that the first contact means (7) engage with the second contact means (14),
**characterized in that**
d) the contacting bridge (10) comprises common bearing surfaces (15, 15') for the purposes of contacting adjacent printed circuit boards (4, 5).

2. An arrangement in accordance with Claim 1, **characterized in that** the contacting bridge (10) comprises at least one bearing surface (15, 15') for each printed circuit board (4, 5) in the vicinity of the second contact means (14).

3. An arrangement in accordance with Claim 1 or 2,
**characterized in that** the contacting bridge (10) is in the form of a block (12) consisting of non-conductive material.

4. An arrangement in accordance with any of the Claims 1 to 3,
**characterized in that** the connecting leads (13) are integrated into the block (12), in particular, by means of a casting process.

5. An arrangement in accordance with any of the preceding Claims, **characterized in that** the first contact means (7) of the printed circuit boards (4, 5) are in the form of contact pads and the second contact means (14) of the contacting bridge (10) are in the form of contact pins.

6. An arrangement in accordance with any of the preceding Claims, **characterized in that** the first contact means (7) of the printed circuit boards (4, 5) are in the form of contact pins and the second contact means (14) of the contacting bridge (10) are in the form of contact pads.

7. An arrangement in accordance with Claim 5 or 6,
**characterized** that the contact pins (14) are in the form of spring pins.

8. An arrangement in accordance with Claim 5 or 6,
**characterized in that** the contact pins (14) are in the form of insert pins.

## Revendications

1. Dispositif pour l'établissement d'un contact pour la mise en contact d'au moins deux plaquettes à circuits imprimés (4,5) disposées dans un boîtier (1), dans lequel
a) chaque plaquette à circuits imprimés (4,5) comporte des premiers moyens de contact (7),
b) dans le boîtier (1) est disposé au moins un étrier de mise en contact (10), qui comporte des lignes de liaison électriquement conductrices (13), dont les extrémités sont réalisées sous la forme de seconds moyens de contact (14), et
c) pour la liaison électrique les plaquettes à circuits imprimés (4,5) sont positionnées l'une par rapport à l'autre au moyen de l'étrier de mise en contact (10) de telle sorte que les premiers moyens de contact (7) engrènent avec les seconds moyens de contact (14),
**caractérisé en ce que**
d) l'étrier de mise en contact (10) pour la mise en contact de plaquettes à circuits imprimés (4,5) disposées côte-à-côte comporte des surfaces d'application communes (15, 15').

2. Dispositif selon la revendication 1, **caractérisé en ce que** l'étrier de mise en contact (10) comporte, dans la zone des seconds moyens de contact (14) pour chaque plaquette à circuits imprimés (4,5) au moins une surface d'appui (15,15').

3. Dispositif selon la revendication 1 ou 2, **caractérisé en ce que** l'étrier de contact (10) est constitué sous la forme d'un bloc (12) formé d'un matériau non conducteur.

4. Dispositif selon l'une des revendications 1 à 3, **caractérisé en ce que** les lignes de liaison (13) sont intégrées dans le bloc (12), notamment par scellement.

5. Dispositif selon l'une des revendications précédentes, **caractérisé en ce que** les premiers moyens de contact (7) des plaquettes à circuits imprimés (4,5) sont réalisés sous la forme de plages de contact et les second moyens de contact (14) de l'étrier de mise en contact (10) sont réalisés sous la forme de tiges de contact.

6. Dispositif selon l'une des revendications précédentes, **caractérisé en ce que** les premiers moyens de contact (7) des plaquettes à circuits imprimés (4,5) sont formés sous la forme de tiges de contact et les seconds moyens de contact (14) de l'étrier de mise en contact (10) sont réalisés sous la forme de plages de contact.

7. Dispositif selon la revendication 5 ou 6, **caractérisé en ce que** les tiges de contact (14) sont réalisées sous la forme de tiges à ressorts.

8. Dispositif selon la revendication 5 ou 6, **caractérisé en ce que** les tiges de contact (14) sont agencées sous la forme de tiges d'enfoncement.
